Europäisches Patentamt

European Patent Office

Office européen des brevets

(19)

(11) Publication number: **0 187 829 B1**

# (12) EUROPEAN PATENT SPECIFICATION

(45) Date of publication of patent specification: **18.12.91**   (51) Int. Cl.⁵: **H01L 41/08**

(21) Application number: **85903621.2**

(22) Date of filing: **08.07.85**

(86) International application number:
**PCT/US85/01298**

(87) International publication number:
**WO 86/00757 (30.01.86 86/03)**

(54) **PIEZOELECTRIC COAXIAL CABLE.**

(30) Priority: **06.07.84 US 628358**
**06.07.84 US 628359**

(43) Date of publication of application:
**23.07.86 Bulletin 86/30**

(45) Publication of the grant of the patent:
**18.12.91 Bulletin 91/51**

(84) Designated Contracting States:
**AT BE CH DE FR GB IT LI NL SE**

(56) References cited:
**EP-A- 0 013 952      GB-A- 2 055 018**
**GB-A- 2 123 602      US-A- 2 042 256**
**US-A- 3 750 127      US-A- 3 798 474**
**US-A- 3 971 250      US-A- 4 369 391**
**US-A- 4 378 721**

(73) Proprietor: **FOCAS LIMITED**
**Cheney Manor Industrial Estate**
**Swindon, Wiltshire, SN2 2PJ(GB)**

(72) Inventor: **SONI, Pravin, Laxminarayan**
**4811 Kenwood Street**
**Union City, CA 94587(US)**
Inventor: **FARRAR, Nigel, Richard**
**853 Runningwood Circle**
**Mountain View, CA 94040(US)**
Inventor: **TURK, Peter**
**64 Schyler Avenue**
**Hayward, CA 94544(US)**
Inventor: **RAUWENDAAL, Christiaan, John**
**1678 Oak Avenue**
**Los Altos, CA 94022(US)**

(74) Representative: **Hardisty, David Robert et al**
**BOULT, WADE & TENNANT 27 Furnival Street**
**London EC4A IPQ(GB)**

**Description**

This invention relates to a piezoelectric coaxial cable and to a method of preparing the cable.

In general terms, a piezoelectric coaxial cable, comprises a central conductor, an intermediate piezoelectric layer surrounding the central conductor, and an outer conductor surrounding the piezoelectric layer. Such piezoelectric coaxial cables have been proposed for use as transducers since, when they are subjected to an applied pressure, for example caused by the impact of an object, or to acoustic pressure changes, a potential difference will be generated between the conductors by the piezoelectric material. Applications for such devices are numerous and include underwater towed-array hydrophones, intrusion detectors, and the like.

In recent years certain polymeric materials, for example poly(vinylidene fluoride) ($PVF_2$) and vinylidene fluoride copolymers have been suggested for use as piezoelectric materials. In order to maximize the piezoelectric properties of a vinylidene fluoride polymer, it is necessary to orient the polymer by stretching it, preferably up to its "natural" draw ratio of about 4:1 or beyond, in order to convert at least a portion of the polymer from its initial alpha or form II crystalline phase into its beta or form I crystalline phase. Simultaneously with, or subsequent to, the stretching operation, it is necessary to polarize the polymer by applying a high electric field gradient across the polymer in a direction perpendicular to the direction of orientation in order to align the dipoles in the beta phase of the polymer. Electric field gradients of from 5 to 200 MV/m are typical for the polarizing operation, the maximum applied field gradient usually being determined by the dielectric breakdown strength of the polymer material.

In order to maximize the piezoelectric response of a piezoelectric coaxial cable the intermediate piezoelectric layer would need to be stretched axially and polarized radially between a central conductor and an outer conductor. While the outer electrode may be applied to the intermediate layer after stretching, or, if a corona polarizing method is employed, the cable may be passed through a corona discharge electrode and an outer conductor for the cable be subsequently provided, significant problems are encountered in the provision of an inner electrode for the cable. It is not possible to extrude the piezoelectric layer onto a conventional metal conductor, e.g., a copper conductor, in that it would then be impossible subsequently to stretch the intermediate layer in order to convert it into the beta-phase. This problem is particularly acute when attempting to make long lengths of piezoelectric coaxial cable.

One solution which has been proposed is to manufacture a piezoelectric coaxial cable by preparing a tape of the piezoelectric polymer, stretching it, polarizing it, and then wrapping it around the inner conductor. (See, for example, U.S. Patent No. 3,798,474 to Cassand et al and U.K. Patent Application No. 2,042,256 to Quilliam.) However, this process is disadvantageous in that it requires numerous steps and may result in poor electrical contact between the piezoelectric polymer and the inner conductor.

U.S. Patent No. 4,303,733 to Bulle discloses filaments which are essentially coaxial cables comprising at least three layers, at least two of which electrically conductive with at least one electrical insulating layer positioned between the two conductive layers. The patent discloses that the intermediate layer may be piezoelectric. It states that where the filament pursuant to the invention is to be provided with piezoelectric characteristics, the core component preferably is compressible, which is achieved either by utilizing hollow filaments or by selection or appropriate synthetic polymers, as for the example, polyolefins with low molecular weight or polyethers. The patent continues to say that a suitable form of execution consists of using as the core component, an electrically conductive, highly viscous liquid with metal and/or carbon black and/or graphite particles dispersed therein. Suitable highly viscous liquids mentioned are, e.g., cis- and transpolyacetylene of relatively low molecular weight.

Further, it is known from GB-A-2123602 to provide for a transducer a center conductor and a molecularly polarized polymer surrounding said conductor, and a second conductor may be disposed over said polymer. Further, it is disclosed in GB-A-2055018 to prepare a detecting member by forming a tube of polyvinylidene fluoride, injecting a lower temperature solder into the tube, stretching the tube (after closing the ends) to form a capilliary tube and then depositing aluminium on the periphery of the tube by vacuum deposition.

We have now discovered that an improved piezoelectric coaxial cable results if the core comprises a high molecular weight polymeric material having conductive particles dispersed therein, and the high molecular weight polymer of the core and the piezoelectric polymer are selected such than an intimate bond is formed between the core and the surrounding piezoelectric layer. A central metallic conductor can extend through the center of the conductive polymer core.

One aspect of this invention relates to a piezoelectric coaxial cable comprising:

   a) a conductive core of a an elastomer having an average molecular weight above 50,000, said elastomer having conductive particles or fibres dispersed therein;

b) a piezoelectric polymer layer which surrounds and is in contact with the conductive core; and

c) an outer conductor surrounding the piezoelectric layer;

said elastomer of the core being intimately bonded to the piezoelectric polymer such that the bond formed between the materials is maintained during stretching and polarizing.

Another aspect of this invention comprises a piezoelectric coaxial cable comprising:

a) a central metallic conductor;

b) a conductive layer of polymer having an average molecular weight above 50,000 said elastomer having conductive particles or fibres dispersed therein which layer surrounds and is in contact with the metallic conductor;

c) a piezoelectric polymer layer which surrounds and is intimately bonded to the conductive elastomer layer such that the bond formed between the materials is maintained during stretching and polarizing; and

d) an outer conductor which surrounds the piezoelectric polymer layer.

Another aspect of this invention provides a method of preparing a piezoelectric coaxial cable as defined above which comprises:

a) extruding the conductive core;

b) extruding the piezoelectric polymer layer around and onto said core thereby forming a composite structure having an intimate bond between the elastomer of the core and the polymer of the piezoelectric layer;

c) stretching the resulting composite structure axially such that the length of the structure is increased at least three times its original length;

d) applying an outer conductor onto the surface of the piezoelectric polymer layer; and

e) polarizing the piezoelectric layer to provide the piezoelectric properties.

Yet another aspect of the invention is concerned with a method of preparing a piezoelectric coaxial cable comprising:

a) providing a central metallic conductor;

b) extruding a conductive elastomer layer over the central conductor;

c) extruding a piezoelectric polymer layer over and onto the conductive elastomer layer thereby forming a composite structure having an intimate bond between the elastomer of the Conductive layer and the polymer of the piezoelectric layer;

d) stretching the resulting composite structure axially;

e) polarizing the piezoelectric polymer layer to render said layer piezoelectric; and

f) applying a second metallic conductor to surround the piezoelectric layer.

The piezoelectric polymer layer is preferably a vinylidene fluoride polymer and the high molecular weight polymeric material of the conductive polymer core is preferably the same polymer as the piezoelectric layer, an elastomer, such as ethylene-ethyl acrylate elastomer, or a thermoplastic elastomer, such as a segmented copolyester thermoplastic elastomer.

Brief Description of the Drawing

Figure 1 shows a cross-sectional view of a typical coaxial cable in accordance with this invention.

Figure 2 shows a cross-sectional view of a typical coaxial cable in accordance with this invention wherein there is a center metallic conductor.

Detailed Description of the Invention

The piezoelectric cable of this invention has a conductive polymer core comprising a high molecular weight polymeric material having conductive particles therein. The polymeric material is selected so that it intimately bonds to the piezoelectric polymer used to make the cable. The term "intimately bonds" is used in the context of this application to mean that the polymeric material and the piezoelectric material of the cable form a bond between them which is maintained during the subsequent stretching and polarizing steps during manufacture of the cable.

The high molecular weight polymeric material should have an average molecular weight above about 50,000, preferably above about 100,000 and most preferably above 150,000. The average molecular weight, Mw, referred to herein is a weight average molecular weight and is calculated by the following formula

$$Mw = \frac{\sum_{x=1}^{\infty} n_x M_x^2}{\sum_{x=1}^{\infty} n_x M_x}$$

where n is the number of moles of species x having molecular weight Mx.

Preferably the polymeric materials used for the conductive core is the same polymer as the piezoelectric polymer, e.g. polyvinylidene fluoride, or other piezoelectric polymer as discussed below, an elastomer or a thermoplastic elastomer.

The term elastomer is used herein to refer to a high molecular weight polymeric material exhibiting a characteristic rubber-like elastic deformability under the action of comparatively small stresses, and returning substantially to its original size and shape upon the removal of the applied stress, and which has an elastic modulus in the uncrosslinked state of 30N/mm$^2$ or less, measured at room temperature using the method of ASTM-D638-72.

Elastomers which can be used in the present invention include, for example, acrylic elastomers, acrylonitrilebutadiene copolymers, chloroprene, chlorinated and chlorosulfonated polyethylenes, epichlorohydrin polymers and fluoroelastomers.

Preferred elastomers are acrylic elastomers, such as ethylene/acrylic ester polymers. Examples of such elastomers include:

a) An ethylene/alkyl acrylate or ethylene-alkyl methacrylate copolymer where the alkyl group has 1-4 carbon atoms; the proportion of the acrylic ester being about 2.4-8.0 moles of ester groups per kilogram of the copolymer.

b) A terpolymer of ethylene with an alkyl acrylate or methacrylate wherein the alkyl group has 1-4 carbon atoms, and a third copolymerizable monomer, which may be, for example one of the following:

i. a $C_1$-$C_{12}$ alkyl monoester or diester of a butenedioic acid,

ii. acrylic acid

iii. methacrylic acid,

iv. carbon monoxide,

v. acrylonitrile,

vi. a vinyl ester,

vii. an alkyl acrylate or alkyl methacrylate, the alkyl group having at least five carbon atoms; and

viii. maleic anhydride.

Typical acrylic elastomers of this type can be a simple copolymer of ethylene with methyl acrylate, ethyl acrylate, propyl acrylate isopropyl acrylate, a butyl acrylate, methyl methacrylate, ethyl methacrylate, propyl methacrylate, isopropyl methacrylate, a butyl methacrylate or vinyl acetate. Such copolymers if not commercially available, can be made by conventional and well know methods.

The terpolymer of ethylene with an acrylic ester and a third monomer may contain as the third monomer an ester of fumaric acid or maleic acid, wherein the alcohol moiety can be, for example, methyl, ethyl, propyl, isopropyl, various isomers of butyl, pentyl, hexyl, heptyl, octyl, nonyl, decyl, undecyl, dodecyl and the like. The third monomer may also be, among others, a vinyl ester such as for example, vinyl acetate or vinyl butyrate.

Excellent results have been obtained using as the elastomer component of the polymer composition a terpolymer of ethylene, methyl acrylate and a cure-site monomer comprising carboxyl groups available from Du Pont under the trade name Vamac (Registered Trade Mark).

Thermoplastic elastomers include, for example, segmented copolyesters, thermoplastic polyurethanes, styrene-butadiene block copolymers, and ionomers. Illustrated thermoplastic elastomers are segmented co-polyesters consisting essentially of recurring intralinear long chain ester units and short chain ester units randomly joined head-to-tail through ester linkages. Such copolyesters are derived, for example, from terephthalic acid, tetramethylene ether glycol and 1,4-butadiene.

The high molecular weight polymer is rendered conductive by dispersing therein conductive particles. The conductive particles can be conductive carbon black, particulate or fibrous graphite, metal particles or metal fibers, or combinations thereof. Preferred are carbon black particles. The resistivity of the conductive polymer material should be less than about 15,000 ohm-cm, preferably less than about 3000 ohm-cm and most preferably less than about 100 ohm-cm. It has been found that during the step of stretching the conductive polymer material during manufacture of the cable, the resistivity of the composition tends to rise. This is particularly true if the polymer used is crystalline. Thus, it is preferred to use a non-crystalline polymeric material. Use of an elastomer, such as elastomeric ethylene-acrylate copolymer or terpolymers, provides a conductive polymer composition whose resistivity remains essentially constant through coextrusion and stretching processes. If, however, it is desired to use a crystalline polymer for the conductive core, annealing of the structure can reduce the resistivity toward its value prior to stretching.

A central metallic conductor can extend through the conductive polymer core. The metallic conductor increases the conductivity of the core. Generally when an electric current is passed through the cable, it will flow through the metallic conductor. However, in the event there is a break in the metallic conductor, the current can flow through the surrounding conductive core thereby preserving conductivity of the cable. As discussed below, the use of a low melting alloy is preferred for the central metallic conductor. These alloys tend to be brittle and thus the ability for conductive polymer to provide continuity at a break in the central metallic conductor can be important.

The central metallic conductor preferably comprises a low melting point (LMPM) so that the inner conductor and the piezoelectric polymer members can be heated to melt the metal and then stretched while the metal is still liquid. In theory any metal having a melting point that is sufficiently low to allow the metal to melt without thermally degrading the conductive and piezoelectric polymer members may be used, although, because the modulus of such metals in general increases with their melting point, it is desirable to select a metal having regard to the softening point of the conductive and piezoelectric polymer layers and having regard to the preferred stretching temperature. Preferably the metal has a melting point of not more than about 170°C, more preferably not more than about 160°C, and especially not more than about 150°C. Also it is preferred for the metal to have a melting point of at least about 65°C and most especially at least about 70°C. The metal forming the inner conductor may be formed from an alloy having an eutectic composition in which case it will exhibit a single, well defined, melting point, or it may be formed from a non-eutectic composition in which case the metal may enter a phase between the solidus and liquidus lines of its phase diagram in which its ductility increases with temperature. It is not necessary for the metal to melt completely for the stretching operation, provided that it becomes sufficiently ductile so that it will not fracture.

In some instances, where it is possible to employ metals having melting points below 100°C, it may be desirable to use bismuth containing alloys that expand as they solidify from the melt.

A piezoelectric polymer layer surrounds the conductive polymer core. The piezoelectric polymer can be, for example poly(ethylene terephthalate), nylon 5, nylon 7, poly(hydroxy-butyrate), poly(acrylonitrile-co-vinyl acetate), and vinylidene fluoride polymers. The term "vinylidene fluoride polymer" is intended to include polyvinylidene fluoride), commonly abbreviated to "PVDF" or "$PVF_2$" and those copolymers of vinylidene fluoride which can be rendered piezoelectric by orientation and polarization. Suitable copolymers include copolymers and terpolymers of vinylidene fluoride with vinyl fluoride, trifluoroethylene, tetrafluoroethylene, vinyl chloride, and chlorotrifluoroethylene. Blends of vinylidene fluoride polymers with other polymers, e.g., poly-(methyl methacrylate), can be used. Composites made from vinylidene fluoride polymers and filled vinylidene fluoride polymers may also be used. Preferably the piezoelectric member comprises a vinylidene fluoride polymer, more preferably poly-(vinylidene fluoride) and especially it consists substantially solely of poly(vinylidene fluoride).

The term piezoelectric polymer is used in this application to designate the polymer which in the final form of the coaxial cable exhibits piezoelectric activity. The polymer initially utilized in extruding the polymer layer surrounding the conductive polymer core, may exhibit little, if any, piezoelectric characteristics.

The piezoelectric polymer layer in the coaxial cable should be from about 0.1 to about 2 millimeters (mm) thick and preferably from about 0.5 to about 1 mm.

The piezoelectric coaxial cable has an outer conductor which surrounds the piezoelectric layer. The outer conductor can be metallic or a conductive polymer composition.

Optionally an outer insulating jacket may be applied around the outer conductor. The jacket may be made from any material which is a good electrical insulator and which provides the desired degree of mechanical protection. For example, polyethylene, vulcanized rubber, or poly(vinyl chloride) can be used. Poly(vinyl chloride) is particularly preferred.

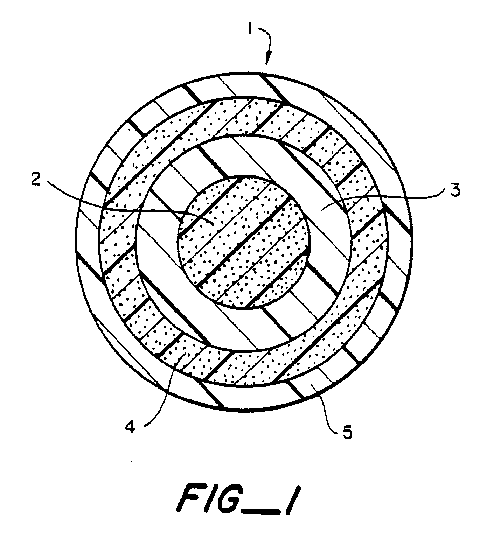

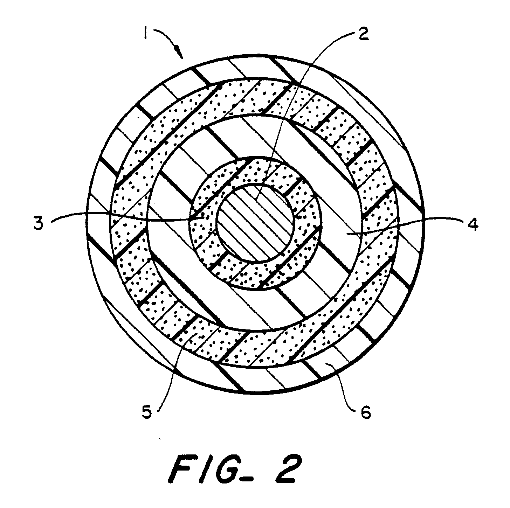

Figure 1 illustrates in cross-section a typical coaxial cable, 1, of this invention. In Fig. 1, a conductive polymer core, 2, of an ethylene-methyl acrylate terpolymer having conductive carbon black dispersed therein. A piezoelectric ($PVF_2$) polymer layer, 3, surrounds the core and outer conductor, 4, surrounds the piezoelectric layer. An outer protective jacket, 5, surrounds the outer conductor. Figure 2 illustrates in cross-section a typical coaxial cable, 1, of this invention which comprises a central metallic conductor, 2. The conductive polymer core, 3, surrounds the central metallic conductor, 2, and in turn is surrounded by a piezoelectric polymer layer, 4, outer conductor, 5, and protective jacket, 6.

In another aspect of this invention, additional layers of the piezoelectric layer, separated from each other by an intervening conductive polymer layer, may be added over the outer conductor, thereby increasing the piezoelectric response. An example of such a construction is a coaxial cable comprising a conductive polymer core, a first piezoelectric polymer layer surrounding the core, a second conductive polymer layer surrounding the first piezoelectric polymer layer, and a second piezoelectric polymer, etc., and finally an outermost conductor which may be either a metal or a conductive polymer.

The conductive polymer core is formed by extruding the conductive polymeric material in the form of an elongate rod of thickness from about 1 to about 5 mm, preferably from about 1.5 to about 3.0 mm. When a center metallic conductor is present, the cable can be prepared by first extruding the metal conductor, in wire or rod form and then extruding a conductive polymer layer around the metal conductor. The piezoelectric polymer layer can be coextruded with the core or can be extruded over the core after it has been produced. In either event an intimate bond is preferably formed between the core and the piezoelectric layer. The resulting composite is stretched then polarized to provide the desired piezoelectric activity.

Where the piezoelectric polymer is PVF2, it generally must be stretched and then polarized in a strong electric field before significant piezoelectric responsiveness develops. Stretching partially or

substantially converts PVF$_2$ from the alpha-phase in which it ordinarily crystallizes from the melt into oriented chains of the more highly polar beta-phase. The stretching temperature is important. The temperature should be high enough so that there is sufficient molecular mobility for individual polymer segments to realign themselves without fracture, but not so high (above about 150°C) so that entire alpha-phase chains are mobile enough to slide past each other instead of stretching to the beta-phase conformation, thus resulting in little conversion, and is preferably between about 60 to 100°C. The amount of stretching should be about 200 to 400 percent, or higher, for example using an ultrahigh drawing procedure.

If desired, the PVF$_2$ or the PVF$_2$ and the conductive polymer core may be crosslinked, for example by gamma or electron beam irradiation, and stretching at a temperature above its melting point.

The outer conductor can be applied directly to the surface of the piezoelectric polymer by, for example, coating it with a conductive paint. Conductive paints comprising a suspension of metal particles, in particular silver particles, dispersed in a liquid vehicle can be employed. The paint can be applied by spraying, brushing, dipping, coating, or the like. Another technique for attaching the outer conductor is to vacuum deposit a layer of highly conductive metal, e.g. silver, onto the surface. Conductive polymer outer conductors can be applied by extrusion or coextrusion.

The poling process (polarization) converts the randomly oriented dipoles of the beta-phase into uniformly oriented ones. Poling may take place during the stretching process or preferably, after stretching has taken place. For poling PVF$_2$, electric fields of 5 to 200 MV/m can be used, but fields of 50 to 150 MV/m are preferred, and about 100 MV/m most preferred. The poling may be done by a contact method, in which case the outer electrode should be provided before the poling. A high voltage connection is made directly to the outer electrode while the inner electrode is connected to the ground, or vice versa. The device is heated to a temperature above the alpha-transition temperature in order to maximize molecular mobility and poled at temperature for about 0.5 to 2.5 hours, and preferably 1 hour. A poling temperature in the range from about 60 to 120°C is preferred and about 80 C most preferred. At the end of this period, the device is cooled while maintaining the voltage in order to freeze in the dipole orientation.

PVF$_2$ can also be poled by a corona discharge, in which case the outer electrode must be provided after the poling. The device is passed through a tubular corona discharge electrode with the inner conductor of the device grounded. Preferred poling times are from a few minutes to half an hour. While corona poling may be performed at temperatures other than room temperature, it is often done at room temperature because temperature control is sometimes inconvenient.

## Example 1

This example illustrates the preparation of a typical coaxial cable of this invention.

A conductive polymer formulation with a resistivity of 12 ohm-cm was prepared by milling an acrylic elastomer (Vamac B-124, DuPont) with 16.0 weight per cent carbon black (Black Pearls 2000, Cabot). It was then extruded using an extruder equipped with a 2.5 mm ID die and operating at a 12 rpm screw speed, 24.5 MPa - 28 MPa (3500-4000 psi) head pressure and a 68°C (zone 1) to 145°C (die) temperature profile.

Poly(vinylidene fluoride) (Solef 1010, Solvay) was then extruded over the rod using the same extruder but operating at 10-20 rpm screw speed, 5.5 MPa (800 psi) pressure and 210°C (zone 1) to 227°C (die) temperature profile.

A segment of this conductive rod surrounded by PVF$_2$ was stretched at 80°C on an Instron mechanical tester equipped with a hot box at a rate of 0.085mm/s (2 in./min.) to approximately the natural draw ratio, i.e. about 300%. The stretched composite structure was coated with conductive silver paint and then poled at about 80°C for 1 hour. The applied voltage was about 35 kV.

The hydrostatic coefficient was measured using a typical method for such measurement as outlined below.

The hydrostatic coefficient was determined to be about 10 pC/N.

The coefficient was measured by placing the sample in a cyclical pressure cell, with the cyclical hydrostatic pressure being applied by a piston displacing a dielectric oil. Typical peak-to-peak pressures used during an experiment are approximately 140 - 1000 kPA (20-140 psi) with a frequency of 3 to 10 Hz. The pressure is measured via a Sensotec A205 transducer and 540D amplifier (accuracy approximately 9 kPa). Signals from both devices were fed into a Nicolet 2090 III digital oscilloscope from which peak-to-peak pressures P and charge Q were determined. The hydrostatic coefficient d3h was then determined as

$$d3h = Q/AP$$

where A is the sample surface area. For a coaxial cable, A is given by

$$A = \frac{2 L t}{L n \left(\frac{R}{R'}\right)}$$

where L is the length, t is the thickness, R is the outer radius, and R' is the inner radius. A common unit for d3h is pC/N (picoCoulombs/Newton). The pyroelectric effect product in such an experiment is not corrected for, as it amounts to only about 5% of the measured activities. Such a correction, if made, would result in an increase of the reported d3h.

## Example 2

A conductive polymer formulation with a resistivity of 12 ohm-cm was prepared by milling an acrylic elastomer (Vamac B-124, Du Pont) with 16.3 weight per cent carbon black (Black Pearls 2000, Cabot). It was then extruded over wire made of an alloy containing bismuth (52.5%), lead (32.0%), and tin (15.5%) and melting at 95 C (Belmont Metals 2531). A 38.1mm (1.5 in.) extruder operating at 7.5 rpm screw speed, 31.5-35 MPa (4500-5000 psi) head pressure, and 65°C (zone 1) to 125°C (die) temperature profile was used. The tooling parameters were: die, 4.19mm (0.165 in.) ID; tip, 2.54mm (0.100 in.) ID and 3.18mm (0.125 in.) OD.

Poly(vinylidene fluoride) (Solef 1008, Solvay) was then extruded over this construction using the same extruder but operating at 20-25 rpm screw speed, 4.9 MPa (700 psi) head pressure, and 210°C (zone 1) to 232°C (die) temperature profile. The tooling parameters were: die, 8.13mm (0.320 in.) ID; tip, 4.42mm (0.170 in.) ID and 5.59mm (0.220 in.) OD.

A segment of this alloy-conductive polymer-PVF₂ combination was stretched at 100°C on an Instron mechanical tester equipped with a hot box at a rate of 0.85 Ms⁻¹ (2 in/min.) to approximately its natural draw ratio, or about 300 per cent.

The stretched combination was coated with conductive silver paint and then poled at 65°C for 1 hour by the contact method. The applied voltage was 35 kV, corresponding to a field of 116 MV/m on allowance for sample thickness. Its hydrostatic coefficient d3h after poling was 12.9 pC/N.

## Example 3

Example 2 was repeated, except that the poling was done at 80°C for 0.5 hour at 35 kV. Two samples were poled, corresponding to fields of 109 MV/m and 113 MV/m on allowance for sample thickness. The d3h's were 9.2 and 10.2 pC/N, respectively.

## Example 4

A conductive polymer formulation with a resistivity of 7 ohm-cm was prepared by mixing in a Banbury mixer an acrylic elastomer (Vamac B-124) with 17.5 weight per cent carbon black (Black Pearls 2000, Cabot). It and a layer of PVF₂ (Solef 1008) were coextruded over the same alloy as in Example 2 (Belmont Metals 2531), with the PVF₂ forming the outermost layer. The alloy was fed as a melt using a zenith gear pump operating at 115°C and 6 rpm. The PVF₂ extruder was a 25.4mm (1 in.) extruder operating at 30 rpm, 4.9 MPa (700 psi), and 170°C (zone 1) to 210°C (die). The conductive polymer extruder was a 31.75mm (1.25 in.) extruder operating at 10 rpm, 7 to 21 MPa (1000 to 3000 psi), and 65°C (zone 1) to 140°C (die). The tooling parameters were: die, 5.46mm (0.215 in.) ID; first tip, 3.81mm (0.150 in.) OD; second tip 2.1mm (0.0825 in.) OD.

A segment of this coextruded combination was stretched under the conditions described for Example 2 and then coated with conductive silver paint.

A sample poled at 80°C for 1 hr. at 25 kV (54 MV/m) by the contact method had a d3h of 10.2 pC/N. Another sample poled at 80°C for 0.5 hr. at 45 kV (134 MV/m) also by the contact method had an activity of 13.1 pC/N.

## Claims

1. A piezoelectric coaxial cable (1) comprising:
   a) a conductive core (2) of an elastomer having an average molecular weight above 50,000, said elastomer having conductive particles or fibres dispersed therein;
   b) a piezoelectric polymer layer (3) which surrounds and is in contact with the conductive core; and
   c) an outer conductor (4) surrounding the piezoelectric layer;
   said elastomer of the core being intimately bonded to the piezoelectric polymer such that the bond formed between the materials is maintained during stretching and polarizing.

2. A cable as claimed in Claim 1 wherein the elastomer of the conductive core is a thermoplastic elastomer.

3. A cable as claimed in Claim 2 wherein said elastomer is an acrylic elastomer.

4. A cable as claimed in Claim 3 wherein said acrylic elastomer is an ethylene-methyl acrylate terpolymer.

5. A cable as claimed in any one of the preceding claims wherein the resistivity of the conductive elastomer core (2) is less than 100 ohm-cm.

6. A cable as claimed in any one of the preceding claims wherein the elastomer has a molecular weight above 100,000.

7. A cable as claimed in any of the preceding claims wherein the piezoelectric polymer layer comprises a vinylidene fluoride polymer.

8. A cable as claimed in Claim 7 wherein the vinylidene fluoride polymer is poly(vinylidene fluoride).

9. A piezoelectric coaxial (11) cable comprising:
a) a central metallic conductor (12);
b) a conductive layer (13) of an elastomer having an average molecular weight above 50,000 said elastomer having conductive particles or fibres dispersed therein which layer surrounds and is in contact with the metallic conductor (12);
c) a piezoelectric polymer layer (14) which surrounds and is intimately bonded to the conductive elastomer layer such that the bond formed between the materials is maintained during stretching and polarizing; and
d) an outer conductor (15) which surrounds the piezoelectric polymer layer.

10. A cable as claimed in Claim 9 wherein the metallic conductor (12) is a metal melting at or below 170° C.

11. A cable as claimed in Claim 9 or Claim 10 wherein the conductive elastomer layer (13) has a resistivity below 500 ohm-cm.

12. A cable as claimed in any one of Claims 9 to 11 wherein the elastomer of the conductive polymer layer is an acrylic elastomer.

13. A cable as claimed in any of Claims 9 to 11 wherein the elastomer of the conductive polymer layer is a fluorinated elastomer.

14. A cable as claimed in any of Claims 9 to 13 wherein the polymer of the piezoelectric layer is a vinylidene fluoride polymer.

15. A cable as claimed in Claim 14 wherein the polymer is vinylidene fluoride homopolymer.

16. A method of preparing a piezoelectric coaxial (1) cable as claimed in any one of Claims 1 to 9 which comprises:
a) extruding the conductive core (2);
b) extruding the piezoelectric polymer layer (3) around and onto said core thereby forming a composite structure having an intimate bond between the elastomer of the core and the polymer of the piezoelectric layer;
c) stretching the resulting composite structure axially such that the length of the structure is increased at least three times its original length;
d) applying an outer conductor (4) onto the surface of the piezoelectric polymer layer (3); and
e) polarizing the piezoelectric layer to provide the piezoelectric properties.

17. A method as claimed in Claim 16 wherein the core and piezoelectric polymer layer are coextruded.

18. A method as claimed in Claim 16 or Claim 17 wherein the composite structure is stretched at a temperature between 60 to 100° C.

19. A method as claimed in Claim 16 wherein the composite structure is stretched prior to the step of polarization.

20. A method as claimed in Claim 16 wherein the composite structure is stretched simultaneously with the step of polarization.

21. A method as claimed in Claim 16 wherein the outer conductor (5) is applied prior to the step of polarization.

22. A method as claimed in Claim 16 wherein the outer conductor (5) is applied after the step of polarization.

23. A method of preparing a piezoelectric coaxial cable (11) as claimed in Claim 9 comprising:
a) providing a central metallic conductor (12);
b) extruding the conductive elastomer layer (13) over the said central conductor;
c) extruding the piezoelectric polymer layer (14) over and onto the conductive elastomer layer (13) thereby forming a composite structure having an intimate bond between the elastomer of the conductive layer and the polymer of the piezoelectric layer;
d) stretching the resulting composite structure axially;

e) polarizing the piezoelectric polymer layer (14) to provide piezoelectric properties; and
f) applying a second metallic conductor (15) to surround the piezoelectric layer (14).

## Revendications

1. Câble coaxial piézoélectrique (1) comportant :
   a) une âme conductrice (2) en un élastomère ayant un poids moléculaire moyen supérieur à 50 000, ledit élastomère contenant en dispersion des particules ou des fibres conductrices ;
   b) une couche de polymère piézoélectrique (3) qui entoure l'âme conductrice avec laquelle elle est en contact ; et
   c) un conducteur extérieur (4) entourant la couche piézoélectrique ;
   ledit élastomère de l'âme étant lié intimement au polymère piézoélectrique de manière que la liaison formée entre les matières soit maintenue durant un étirage et une polarisation.

2. Câble selon la revendication 1, dans lequel l'élastomère de l'âme conductrice est un élastomère thermoplastique.

3. Câble selon la revendication 2, dans lequel ledit élastomère est un élastomère acrylique.

4. Câble selon la revendication 3, dans lequel ledit élastomère acrylique est un terpolymère éthylèneacrylate de méthyle.

5. Câble selon l'une quelconque des revendications précédentes, dans lequel la résistivité de l'âme conductrice (2) en élastomère est inférieure à 100 ohms.cm.

6. Câble selon l'une quelconque des revendications précédentes, dans lequel l'élastomère a un poids moléculaire supérieur à 100 000.

7. Câble selon l'une quelconque des revendications précédentes, dans lequel la couche de polymère piézoélectrique comprend un polymère de fluorure de vinylidène.

8. Câble selon la revendication 7, dans lequel le polymère de fluorure de vinylidène est du poly(fluorure de polyvinylidène).

9. Câble coaxial piézoélectrique (11) comportant :
   a) un conducteur métallique central (12) ;
   b) une couche conductrice (13) en un élastomère ayant un poids moléculaire moyen supérieur à 50 000, ledit élastomère contenant en dispersion des particules ou des fibres conductrices, laquelle couche entoure le conducteur métallique (12) avec lequel elle est en contact ;
   c) une couche de polymère piézoélectrique (14) qui entoure la couche conductrice d'élastomère à laquelle elle est liée intimement, de manière que la liaison formée entre les matières soit maintenue durant un étirage et une polarisation ; et
   d) un conducteur extérieur (15) qui entoure la couche de polymère piézoélectrique.

10. Câble selon la revendication 9, dans lequel le conducteur métallique (12) est en un métal fondant à ou au-dessous de 170°C.

11. Câble selon la revendication 9 ou la revendication 10, dans lequel la couche conductrice d'élastomère (13) présente une résistivité inférieure à 500 ohms.cm.

12. Câble selon l'une quelconque des revendications 9 à 11, dans lequel l'élastomère de la couche conductrice de polymère est un élastomère acrylique.

13. Câble selon l'une quelconque des revendications 9 à 11, dans lequel l'élastomère de la couche conductrice de polymère est un élastomère fluoré.

14. Câble selon l'une quelconque des revendications 9 à 13, dans lequel le polymère de la couche piézoélectrique est un polymère de fluorure de vinylidène.

15. Câble selon la revendication 14, dans lequel le polymère est un homopolymère de fluorure de vinylidène.

16. Procédé de préparation d'un câble coaxial piézoélectrique (1) selon l'une quelconque des revendications 1 à 9, qui consiste :
   a) à extruder l'âme conductrice (2) ;
   b) à extruder la couche de polymère piézoélectrique (3) autour et sur ladite âme afin de former une structure composite ayant une liaison intime entre l'élastomère de l'âme et le polymère de la couche piézoélectrique ;
   c) à étirer axialement la structure composite résultante de manière que la longueur de la structure soit augmentée d'au moins trois fois sa longueur d'origine ;
   d) à appliquer un conducteur extérieur (4) sur la surface de la couche de polymère piézoélectrique (3) ; et
   e) à polariser la couche piézoélectrique pour établir les propriétés piézoélectriques.

17. Procédé selon la revendication 16, dans lequel l'âme et la couche de polymère piézoélectrique sont co-extrudées.

18. Procédé selon la revendication 16 ou la revendication 17, dans lequel la structure composite est étirée à une température comprise entre 60 et 100˚ C.

19. Procédé selon la revendication 16, dans lequel la structure composite est étirée avant l'étape de polarisation.

20. Procédé selon la revendication 16, dans lequel la structure composite est étirée simultanément à l'étape de polarisation.

21. Procédé selon la revendication 16, dans lequel le conducteur extérieur (5) est appliqué avant l'étape de polarisation.

22. Procédé selon la revendication 16, dans lequel le conducteur extérieur (5) est appliqué après l'étape de polarisation.

23. Procédé de préparation d'un câble coaxial piézoélectrique (11) selon la revendication 9, consistant :

a) à fournir un conducteur métallique central (12) ;

b) à extruder la couche conductrice d'élastomère (13) sur ledit conducteur central ;

c) à extruder la couche de polymère piézoélectrique (14) au-dessus de et sur la couche conductrice d'élastomère (13), afin de former une structure composite ayant une liaison intime entre l'élastomère de la couche conductrice et le polymère de la couche piézoélectrique ;

d) à étirer axialement la structure composite résultante ;

e) à polariser la couche de polymère piézoélectrique (14) pour conférer des propriétés piézoélectriques ; et

f) à appliquer un second conducteur métallique (15) afin qu'il entoure la couche piézoélectrique (14).

**Patentansprüche**

1. Piezoelektrisches Koaxialkabel (1) mit

a) einem leitfähigen Kern (2) aus einem Elastomer mit einem mittleren Molekulargewicht von mehr als 50.000, wobei in dem Elastomer leitfähige Teilchen oder Fasern dispergiert sind;

b) einer piezoelektrischen Polymerschicht (3), die den leitfähigen Kern umgibt und kontaktiert; und

c) einem Außenleiter (4), der die piezoelektrische Schicht umgibt; wobei das Elastomer des Kerns mit dem piezoelektrischen Polymer innig verbunden ist, so daß die Bindung, die zwischen den Materialen gebildet ist, während des Streckens und Polarisierens aufrecht erhalten wird.

2. Kabel nach Anspruch 1, wobei das Elastomer des leitfähigen Kerns ein thermoplastisches Elastomer ist.

3. Kabel nach Anspruch 2, wobei das Elastomer ein Acryl-Elastomer ist.

4. Kabel nach Anspruch 3, wobei das Acryl-Elastomer ein Ethylen-Methyl-Acrylester-Terpolymer ist.

5. Kabel nach jedem der vorstehenden Ansprüche, wobei der spezifische Widerstand des leitfähigen Elastomers (2) weniger als 100 Ω-cm ist.

6. Kabel nach jedem der vorstehenden Ansprüche, wobei das Elastomer ein Molekulargewicht von über 100.000 hat.

7. Kabel nach jedem der vorstehenden Ansprüche, wobei die piezoelektrische Polymerschicht ein Vinylidenfluoridpolymer enthält.

8. Kabel nach Anspruch 7, wobei das Vinylidenfluoridpolymer ein Poly-Vinylidenfluorid ist.

9. Piezoelektrisches Koaxialkabel (11) mit

a) einem zentralen Metalleiter (12);

b) einer leitfähigen Schicht (13) aus einem Elastomer mit einem mittleren Molekulargewicht von über 50.000, wobei das Elastomer dispergierte leitfähige Teilchen oder Fasern enthält, und die Schicht den Metalleiter (12) umgibt und diesen kontaktiert;

c) einer piezoelektrischen Polymerschicht (14), die die leitfähige Elastomerschicht umgibt und mit dieser innig verbunden ist, so daß die Bindung die zwischen den Materialien gebildet ist, während dem Strecken und Polarisieren aufrecht erhalten wird; und

d) einem Außenleiter (15), der die piezoelektrische Polymerschicht umgibt.

10. Kabel nach Anspruch 9, wobei der Metalleiter (12) ein Metall ist, das unterhalb von 170 Grad Celsius schmilzt.

11. Kabel nach Anspruch 9 oder 10, wobei die leitfähige Elastomerschicht (13) einen spezifischen Widerstand unterhalb von 500 Ω-cm hat.

12. Kabel nach jedem der Ansprüche 9 bis 11, wobei das Elastomer der leitfähigen Polymerschicht ein Acryl-Elastomer ist.

13. Kabel nach jedem der Ansprüche 9 bis 11, wobei das Elastomer der leitfähigen Polymerschicht ein fluoriniertes Elastomer ist.

14. Kabel nach jedem der Ansprüche 9 bis 13, wobei das Polymer der piezoelektrischen Schicht ein Vinylidenfluoridpolymer ist.

15. Kabel nach Anspruch 14, wobei das Polymer ein Vinyliden-Fluorid-Homopolymer ist.

16. Verfahren zum Herstellen eines piezoelektrischen Koaxialkabels (1) nach jedem der Ansprüche 1 bis 9 mit den Schritten:
    a) Extrudieren des leitfähigen Kerns (2),
    b) Extrudieren der piezoelektrischen Polymerschicht (3) um und auf den Kern, wobei eine zusammengesetzte Struktur mit einer innigen Bindung zwischen dem Elastomer des Kerns und dem Polymer der piezoelektrischen Schicht gebildet wird;
    c) Strecken der resultierenden zusammengesetzten Struktur in axialer Richtung, so daß die Länge der Struktur um wenigstens das Dreifache der ursprünglichen Länge erhöht wird;
    d) Aufbringen eines Außenleiters (4) auf die Oberfläche der piezoelektrischen Polymerschicht (3); und
    e) Polarisieren der piezolektrischen Schicht, um die piezoelektrischen Eigenschaften zu erzeugen.

17. Verfahren nach Anspruch 16, wobei der Kern und die piezoelektrische Polymerschicht zusammen extrudiert werden.

18. Verfahren nach Anspruch 16 oder 17, wobei die zusammengesetzte Struktur bei einer Temperatur zwischen 60 Grad Celsius und 100 Grad Celsius gestreckt wird.

19. Verfahren nach Anspruch 16, wobei die zusammengesetzte Struktur vor dem Schritt Polarisieren gestreckt wird.

20. Verfahren nach Anspruch 16, wobei die zusammengesetzte Struktur gleichzeitig mit dem Schritt Polarisieren gestreckt wird.

21. Verfahren nach Anspruch 16, wobei der Außenleiter (5) vor dem Schritt Polarisieren aufgebracht wird.

22. Verfahren nach Anspruch 16, wobei der Außenleiter (5) nach dem Schritt Polarisieren aufgebracht wird.

23. Verfahren zum Herstellen eines piezoelektrischen Kabels (11) nach Anspruch 9, mit den Schritten:
    a) Herstellen eines zentralen Metalleiters (12);
    b) Extrudieren der leitfähigen Elastomerschicht (13) auf den zentralen Leiter;
    c) Extrudieren der piezoelektrischen Polymerschicht (14) über und auf die leitfähige Elastomerschicht (13); wodurch eine zusammengesetzte Struktur erzeugt wird, die eine innige Verbindung zwischen dem Elastomer der leitfähigen Schicht und dem Polymer der piezoelektrischen Schicht hat;
    d) Strecken der resultierenden, zusammengesetzten Struktur in axialer Richtung;
    e) Polarisieren der piezoelektrischen Polymerschicht (14) zum Erzeugen piezoelektrischer Eigenschaften; und
    f) Aufbringen eines zweiten Metalleiters (15), der die piezoelektrische Schicht (14) umgibt.

FIG_1

FIG_ 2